# EUROPEAN PATENT SPECIFICATION

(11) **EP 2 883 240 B1**
(45) Date of publication and mention of the grant of the patent: **02.09.2020**
(21) Application number: 13828359.3
(22) Date of filing: 18.07.2013
(51) Int. Cl.: H01L 21/768, H01L 21/285, C23C 14/54

(54) **METHOD AND APPARATUS DEPOSITION PROCESS SYNCHRONIZATION**
VERFAHREN UND VORRICHTUNG FÜR ABSCHEIDUNGSVERFAHRENSSYNCHRONISATION
PROCÉDÉ ET APPAREIL DE SYNCHRONISATION DE TRAITEMENT DE DÉPÔT

(30) Priority: 09.08.2012 US 201213570712
(43) Date of publication of application: 17.06.2015
(73) Proprietor: Applied Materials, Inc., Santa Clara, CA 95054 (US)
(72) Inventor: LAM, Winsor, San Francisco, California 94116 (US); MILLER, Keith A., Sunnyvale, California 94089 (US); JOHNSON, Carl, Tracy, California 95377 (US); RIKER, Martin Lee, Milpitas, California 95035 (US); XU, Ye, Campbell, California 95008 (US)
(74) Representative: Zimmermann & Partner Patentanwälte mbB
(86) International application number: PCT/US2013/051017
(87) International publication number: WO 2014/025508

(56) References cited:
- JP-A- 2011 149 093
- US-A1- 2002 117 399
- US-A1- 2003 034 244
- US-A1- 2004 140 196
- US-A1- 2009 078 678
- US-A1- 2011 256 726
- US-A1- 2012 070 982
- US-A1- 2012 098 575
- US-B1- 6 413 382
- US-B2- 6 794 301

## Description

### FIELD

Embodiments of the present invention generally relate to controlling processing conditions during physical vapor deposition processes

### BACKGROUND

Integrated circuits have evolved into complex devices that can include millions of components (*e.g*., transistors, capacitors and resistors) on a single chip. The evolution of chip designs continually requires faster circuitry and greater circuit density. The demands for greater circuit density necessitate a reduction in the dimensions of the integrated circuit components. As the dimensions decrease, processing of the integrated chip substrates become increasingly more challenging.

For example, in conventional substrate processing, thin layers of material are applied to the inner surfaces of substrate features prior to filling the feature with conductive material. Ideally, the thin layer would be consistent throughout the feature, while minimizing overhang (excessive material on surfaces of the opening of the feature), which can reduce the size of the feature opening, or close the opening completely (undesirably leaving an air gap, or void, trapped within the feature). As the dimensions of the integrated circuit components decrease, the aspect ratio of the height of the feature to the width of the feature increases, further exacerbating the challenge of consistent deposition of the thin layer.

Typical processes commonly used for fabricating integrated circuits having such high aspect ratio features include depositing material in a bottom of the features and re-sputtering the material to facilitate redistribution from the bottom to the sidewalls of the feature. This is done using high energy ions directed toward the substrate. Unfortunately, this method may cause damage to the underlying layers and the substrate itself, particularly at the corners, or bevel, and bottom of the feature. This damage results in significant line resistance increase and reliability degradation. In addition, unfavorable results of typical processes include overhang buildup, which may close up the feature, with the effect becoming more prevalent at smaller feature geometries (e.g., at higher aspect ratios).

Furthermore, the inventors have observed that attempts to solve the aforementioned problems by varying the ion density and energy through controlling the DC, RF powers and electromagnet current results film thickness variations across the wafer and from wafer-to-wafer due to delays in signal processing with respect to the power supplies. JP2011149093 discloses a sputtering system and method in which different elements like sputter targets, DC sources and shutters are centrally controlled in a serial communication system. Due to unwanted time delays caused by the serial communication, the timing of the control signals is synchronised in such a way that these delays are taken into account.

Therefore, the inventors have provided improved methods for forming thin layers of material to the inner surfaces of high aspect ratio features.

### SUMMARY

Methods and apparatus for processing a substrate are provided herein. In some embodiments, a method for processing a substrate in a process chamber, includes receiving, by the synchronization controller, process control parameters for one or more devices from a process controller to perform a first chamber process, determining, by the synchronization controller, a time to send each of the process control parameters to the one or more devices, for each of the one or more devices, adjusting, by the synchronization controller, the determined time to send each of the process control parameters using specific signal process delays associated with each of the one or more devices wherein the specific signal processing delays include intrinsic delays associated with each of the one or more devices, and sending, by the synchronization controller, the process control parameters to each of the one or more devices at the adjusted times to perform the first chamber process, wherein the synchronization controller includes one or more output channels, each channel directly coupled to one of the one or more devices.

In some embodiments, a substrate processing system includes a synchronization controller having one or more inputs to receive process control parameters of one or more devices from a process controller, and one or more output channels, each output channel directly coupled to one of the one or more devices, wherein the synchronization controller is configured to (a) receive the process control parameters, (b) determine a time to send each of the process control parameters to the one or more devices, c) for each of the one or more devices, adjust the determined time to send each of the process control parameters using specific signal process delays associated with each of the one or more devices, wherein the specific signal processing delays include intrinsic delays associated with each of the one or more devices, and (d) send the process control parameters to each of the one or more devices at the adjusted times to perform a first chamber process.

In an example useful for understanding the invention, a method for forming layers on a substrate having one or more features includes performing a first substrate process on the first layer using a first energy process regime to build up a bottom portion of the one or more features with the first material and performing a second substrate process on the first layer using a second energy process regime to redistribute the first material from the bottom portion of the one or more features to a sidewall of the one or more features, wherein the second energy process regime is higher than the first energy process regime.

### BRIEF DESCRIPTION OF THE DRAWINGS

Embodiments of the present invention, briefly summarized above and discussed in greater detail below, can be understood by reference to the illustrative embodiments of the invention depicted in the appended drawings. It is to be noted, however, that the appended drawings illustrate only typical embodiments of this invention and are therefore not to be considered limiting of its scope, for the invention may admit to other equally effective embodiments.
Figure 1 depicts a method for the processing of a semiconductor substrate in accordance with some embodiments of the present invention.
Figures 2A-2F are illustrative cross-sectional views of a substrate during different stages of the processing sequence in accordance with some embodiments of the present invention.
Figure 3 depicts an apparatus suitable for processing semiconductor substrates in accordance with some embodiments of the present invention.
Figure 4A is a schematic of a conventional control system for controlling support systems in substrate processing.
Figure 4B is a chart showing an exemplary signal delay associated with conventional control systems for controlling support systems in substrate processing.
Figure 5 is a schematic of an exemplary control system including a separate synchronization controller in accordance with some embodiments of the present invention.
Figure 6 depicts a method for synchronizing the control of support systems associated with processing of a semiconductor substrate in accordance with some embodiments of the present invention.

To facilitate understanding, identical reference numerals have been used, where possible, to designate identical elements that are common to the figures. The figures are not drawn to scale and may be simplified for clarity. It is contemplated that elements and features of one embodiment may be beneficially incorporated in other embodiments without further recitation.

### DETAILED DESCRIPTION

In ionized physical vapor deposition (PVD) copper processes, metal ions are accelerated from a target source material and deposited into via and trench structures (i.e., features) formed on a substrate. The inventors have discovered that by varying the ion density and energy, step coverage of the feature (*e.g*., a thickness of the deposited material on horizontal surfaces as compared to a thickness of the deposited material on vertical surfaces) may be tailored by adjusting the ion/neutral metal ratio, trajectory and sputter yield. Typically a PVD copper deposition process is operated in the high metal ion ratio regime at varying ion energies. By varying the energy of incoming ions, distinct process regimes are realized. At medium ion energy process regimes, a high bottom deposition process is observed with minimum resputtering on the substrate. At higher energy process regimes, the ions may physically etch the substrate. The inventors have discovered that combining the medium energy and high energy processes, in a multi-step process, favorable step coverage for copper ion reflow or electrochemical deposition, or plating (ECP) gap fill may be realized while minimizing or preventing damage to the substrate or the feature.

In addition, the inventors have also observed that by synchronizing the sending of process parameters (e.g., magnetron position, electromagnet current, DC and RF powers), improvements can be realized in deposition performance (step coverage, uniformity), repeatability of process results, and reliability of hardware components. By using a separate programmable logic controller to synchronize the sending of process parameters, delay times for controlling power supplies, for example, can be greatly decreased. Specifically, in embodiments, synchronization of DC and RF power supply response times have been improved from, for example, 300ms delay to 30ms delay. The inventors have also observed that by synchronizing the DC and RF power supply response times, substrate wafer edge uniformity has been improved, for example, from 7% to 2.5%. In addition, in at least some embodiments, wafer-to-wafer repeatability is also improved by a similar margin. Furthermore, by synchronizing the sending of process parameters to the process devices, arcing within the process chamber may be prevented by more accurately controlling when certain devices are turned on and off.

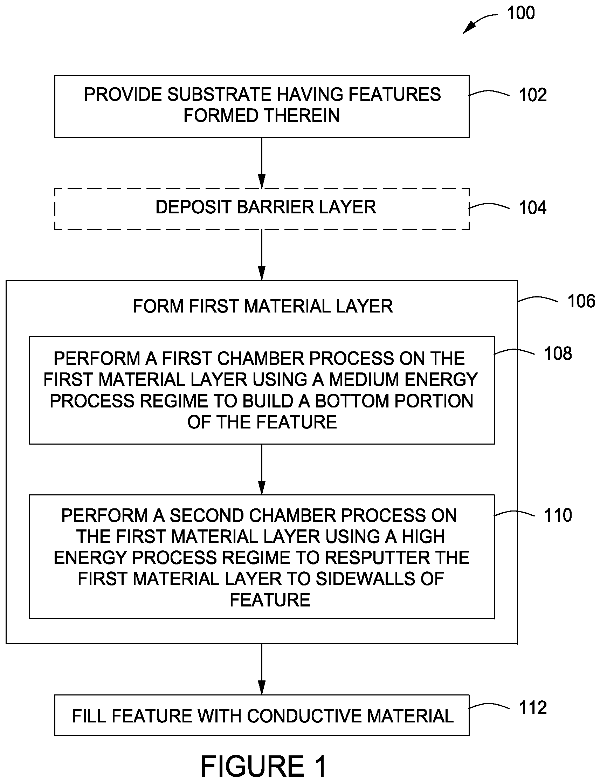

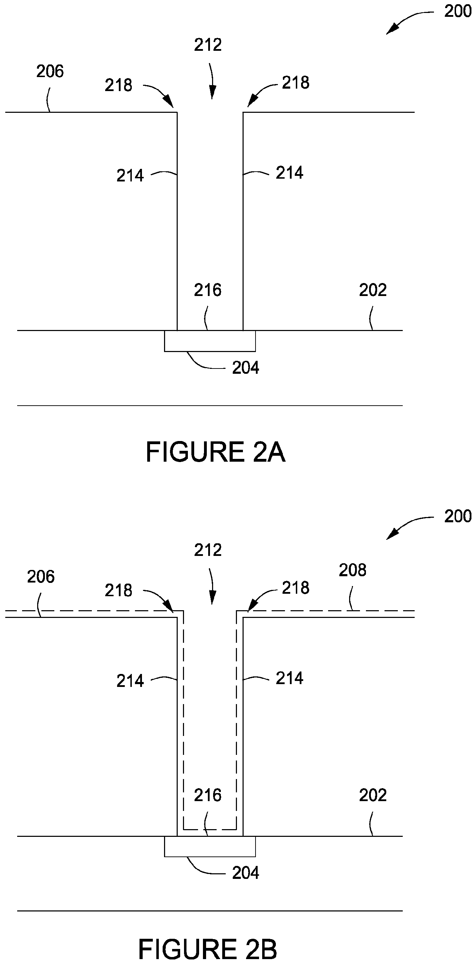

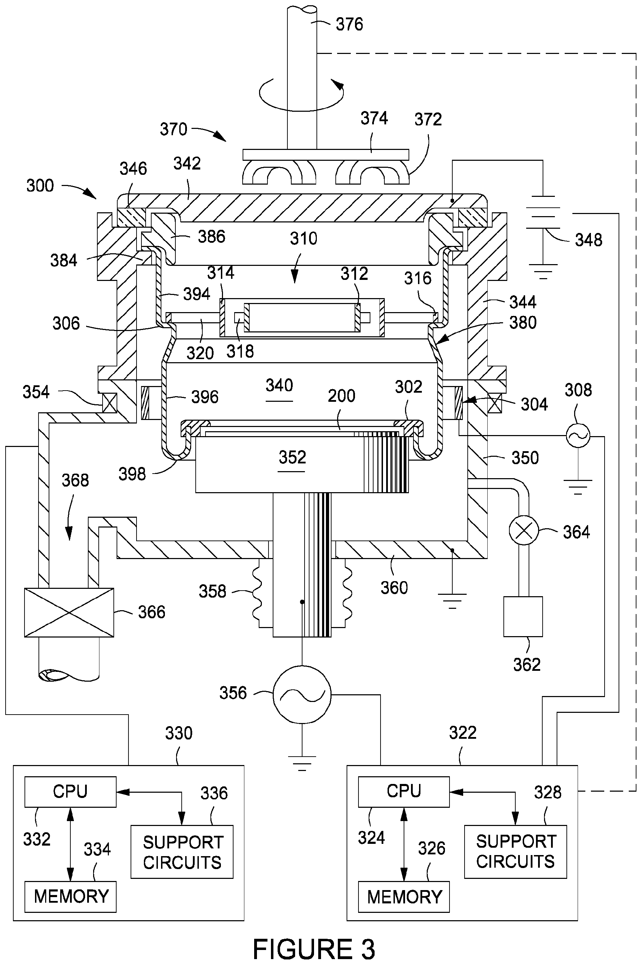

Figure 1 depicts a method 100 for processing of substrates in accordance with some embodiments of the present invention. Figures 2A-F are illustrative cross-sectional views of a substrate during different stages of the method depicted in Figure 1. The method 100 may be performed in any suitable substrate process chamber having both DC and radio frequency (RF) power sources, such as a process chamber 300 described below and depicted in Figure 3.

The method 100 begins at 102, where a substrate 200 having a feature, such as opening 212, formed therein is provided, as depicted in Figure 2A. The substrate 200 may be any suitable substrate, such as a silicon substrate, a III-V compound substrate, a silicon germanium (SiGe) substrate, an epi-substrate, a silicon-on-insulator (SOI) substrate, a display substrate such as a liquid crystal display (LCD), a plasma display, an electro luminescence (EL) lamp display, a light emitting diode (LED) substrate, a solar cell array, solar panel, or the like. In some embodiments, the substrate 200 may be a semiconductor wafer (e.g., a 200 mm, 300 mm, 450 mm, or the like silicon wafer).

In some embodiments, the substrate 200 may comprise one or more layers, for example, such as a bulk dielectric layer 206 formed over a dielectric layer 202, as depicted in Figure 2A. A conductive feature 204 may be formed in an upper region of the dielectric layer 202 such that an upper surface of the conductive feature 204 may be exposed by the opening 212 formed in the bulk dielectric layer 206. For example, a via/trench etching process may be performed to define the opening 212 in the bulk dielectric layer 206, thereby exposing an upper surface of the conductive feature 204. The conductive feature 204 may be fabricated from any suitable conductive material. For example, for a copper interconnect, the conductive feature 204 may be a copper layer embedded in the dielectric layer 202. In some embodiments, the conductive feature 204 may be fabricated from a metal, such as copper, aluminum, tungsten, or the like, alloys thereof, or combinations thereof.

The bulk dielectric layer 206 and the dielectric layer 202 may be fabricated from the same or different dielectric materials. In some embodiments, the dielectric materials may comprise silicon oxide (SiO₂), silicon nitride (SiN), a low-k material, or the like. The low-k material may be carbon-doped dielectric materials (such as carbon-doped silicon oxide (SiOC), BLACK DIAMOND® dielectric material available from Applied Materials, Inc. of Santa Clara, California, or the like), an organic polymer (such as polyimide, parylene, or the like), organic doped silicon glass (OSG), fluorine doped silicon glass (FSG), or the like. As used herein, low-k materials are materials having a dielectric constant less than about that of silicon oxide, which is about 3.9.

The opening 212 is generally defined by one or more sidewalls 214, a bottom surface 216 and upper corners (bevel) 218. The opening 212 may be any feature suitable for substrate fabrication, for example such as a via, a trench, a dual damascene feature, or the like, and may be formed by any suitable process or processes such as etching. Although only one opening 212 is shown, multiple features may be simultaneously processed in accordance with the teachings disclosed herein. The opening 212 may generally have any dimensions. For example, in some embodiments, the opening 212 may have a ratio of a height of the feature to a width of the feature of at least about 2:1. In some embodiments, the opening 212 may be a high aspect ratio feature. In such embodiments, the opening 212 may have a ratio of a height of the feature to a width of the feature of at least about 4:1. In some embodiments, the opening 212 may have a width of about 5 to about 50 nm.

Although the substrate 200 is depicted as having a bulk dielectric layer 206 formed over a dielectric layer 202, the substrate 200 may also include different and/or additional material layers. In addition, other features, such as trenches, vias, or the like, may be formed in different and/or additional material layers.

Next, at 104, a barrier layer 208 may be optionally deposited atop the substrate 200. When present, the barrier layer 208 may serve as an electrical and/or physical barrier between the substrate and layers to be subsequently deposited in the opening, and/or may function as a better surface for attachment during the deposition process discussed below than a native surface of the substrate. The barrier layer 208 may comprise any materials suitable to perform the above discussed functions. For example, in some embodiments, the barrier layer 208 may comprise one or more of titanium (Ti), tantalum (Ta), oxides or nitrides thereof, or the like. The barrier layer 208 may be deposited to any suitable thickness, for example, about 0.5 to about 10 nm.

The barrier layer 208 may be deposited by any suitable method, for example, such as chemical vapor deposition (CVD), physical vapor deposition (PVD), or the like. For example, in some embodiments, the barrier layer 208 may be deposited via a PVD process in a suitable process chamber, such as the process chamber 300 described below with respect to Figure 3. In such embodiments, the process chamber may have a target (e.g. target 342) disposed therein that comprises a source material to be deposited atop the substrate 200. For example, in embodiments where the barrier layer comprises tantalum nitride (TaNₓ), the target may comprise tantalum (Ta).

In some embodiments, depositing the barrier layer 208 may include providing a process gas to the process chamber and forming a plasma from the process gas to react with source material from the target. The reaction causes the target to eject atoms of the target material, which are then directed towards the substrate 200. In some embodiments, the process gas may comprise an inert gas, such as argon (Ar), helium (He), krypton (Kr), neon (Ne), xenon (Xe), or the like. The process gas may be provided at a flow rate of between about 2 to about 200 sccm. In some embodiments, about 5 to about 40 kW of DC power may be applied to the target to ignite the process gas and maintain a plasma.

In some embodiments, to facilitate directing the ejected atoms from the target towards the substrate 200 a bias power in the form of RF power may be applied to a substrate support pedestal (e.g., substrate support pedestal 352 discussed below) supporting the substrate 200. In such embodiments about 50 to about 2000 W of RF power may be supplied at a frequency of between 2 to about 60 MHz, or about 13.56 MHz.

In addition to the above, additional process parameters may be utilized to facilitate depositing the barrier layer 208. For example, in some embodiments, the process chamber may be maintained at a pressure of about 0.2 to about 50 mTorr. In addition, in some embodiments, the process chamber may be maintained at a temperature of about -20 degrees Celsius to about +400 degrees Celsius.

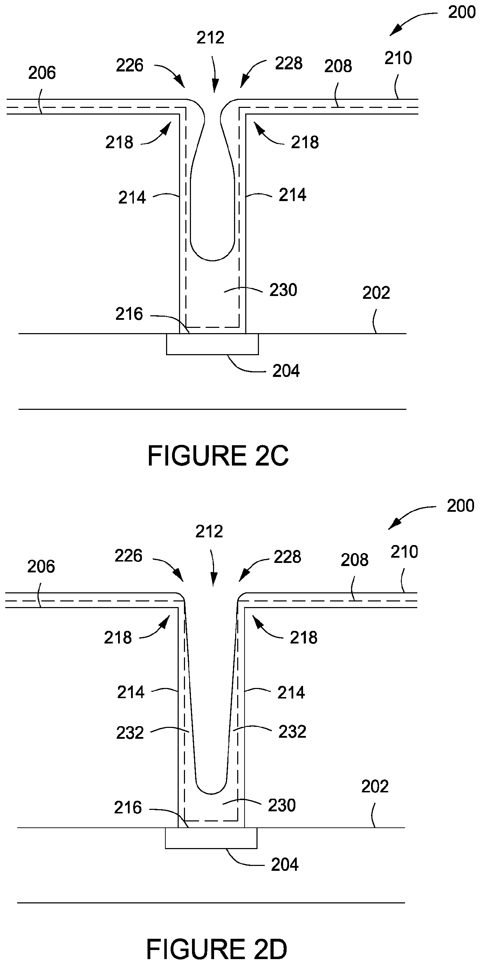

Next, at 106, an initial seed layer 210 (i.e., a first material layer) may be deposited within the opening 212, as depicted in Figure 2C. The seed layer 210 provides a better surface for attachment and may act as a template for subsequently deposited materials, for example, such as the conductive materials discussed below. The seed layer 210 may comprise any materials suitable to provide the aforementioned functions. For example, in some embodiments, the seed layer may comprise one of copper (Cu), ruthenium (Ru), cobalt (Co), or the like, and alloys thereof, such as copper-aluminum (Cu-AI), copper-manganese (Cu-Mn), copper-magnesium (Cu -Mg), or the like.

To form the initial seed layer 210 (*e.g.,* a first material layer), in some embodiments, a multi-step deposition and/or etch process may be used. First at 108, a first chamber process may be performed on the substrate 200 to form the seed layer 210. In some embodiments, the initial seed layer 210 may be deposited within the opening 212 (and atop the substrate 200), as depicted in Figure 2C, using a low to medium energy process regime. The seed layer 210 may be deposited via any deposition process suitable to form the seed layer having a desired profile, for example, such as PVD, CVD, or the like. For example, in some embodiments, the seed layer 210 may be deposited via a PVD process in a suitable process chamber, such as the process chamber 300 described below with respect to Figure 3. In such embodiments, the process chamber may have a target (e.g. target 342) disposed therein that comprises a source material to be deposited atop the substrate 200. For example, in embodiments where the seed layer 210 comprises copper (Cu), the target may comprise a copper (Cu) source material.

In some embodiments, depositing the seed layer 210 may include providing a process gas to the process chamber to physically sputter source material from the target, e.g., to cause the target to eject atoms of the target material, which are then directed towards the substrate 200. In some embodiments, the process gas may comprise an inert gas, such as argon (Ar), helium (He), krypton (Kr), neon (Ne), xenon (Xe), or the like. The process gas may be provided at a flow rate of between about 4 to about 300 sccm, or in some embodiments, about 4 sccm. In some embodiments, a plasma may be formed from the process gas to facilitate sputtering the source material from the target. In such embodiments, about 5 kW to about 60 kW of DC power, or in some embodiments, about 30 kW of DC power may be applied to the target to ignite the process gas and maintain the plasma. A target voltage (i.e., sputter voltage) between -300 v to -1400 v may be applied to the target to induce sputtering. In some embodiments, an exemplary target voltage of -750v is applied to the target. By using a low/medium DC energy process regime to sputter the target material in combination with applying RF bias energy, the target source material ions (*e.g.,* Cu ions) enter the feature of the substrate (*e.g.,* via and/or trench) at a nearly vertical trajectory. Due to the low energy of the target source material ions, a bottom portion of the feature 230 is built up with target source material ions that don't resputter to other portions of the substrate.

In some embodiments, to facilitate directing the ejected atoms from the target towards the substrate 200 a bias power in the form of RF power may be applied to a substrate support pedestal (*e.g.*, substrate support pedestal 352) supporting the substrate 200. In such embodiments, about 50 W to about 2000 W of RF power, or in some embodiments about 120 W of RF power may be supplied at a frequency of between 2 MHz to about 60 MHz, or about 13.56 MHz. In addition, in some embodiments a substrate pedestal voltage of between +150 v to -750 v may be applied. In an exemplary multistep deposition/etch process, a substrate pedestal voltage of -120 v, to -240 v, and back to -50 v may be applied.

In addition to the above, additional process parameters may be utilized to facilitate depositing the seed layer 210. For example, in some embodiments, the process chamber may be maintained at a pressure of about 0.1 to about 50 mTorr. In addition, in some embodiments, the process chamber may be maintained at a temperature of about 20 to about 200 degrees Celsius.

In some embodiments, the inventors have observed that when depositing the seed layer 210 via the low/medium energy deposition processes as described above with respect to step 108 to build the bottom substrate features 230, the seed layer material may accumulate near the upper corners 218 of the opening 212 as shown in Figure 2C. In conventional processing, the accumulation of seed layer material may partially or fully close off the opening 212 and create a void.

Accordingly, at 110 a second chamber process may be performed on the substrate 200. At 110, the seed layer 210 is etched/resputtered in a high energy process regime to remove at least a portion of the seed layer 210 proximate the upper corners 218 of the opening 212, as depicted in Figure 2D (*e.g*., to provide an etched seed layer). By etching/resputtering at least a portion of the seed layer 210, the thickness of the seed layer 210 may be controlled at desired locations along the sidewalls 214 and proximate the upper corners 218 of the opening 212 to provide an inwardly sloped seed layer profile (*e.g*., the average seed layer thickness increases from an upper portion 226, 228 of the opening 212 towards the bottom 216 of the opening 212), such as depicted in Figure 2D. For example, in some embodiments, a thickness of the seed layer 210 formed on the sidewalls 232 proximate the bottom 216 of the opening 212 may be about 2 to about 10 nm and a thickness of the seed layer 210 formed on the sidewalls 232 proximate the upper portion of the opening 212 may be about 1 to about 5 nm. In some embodiments, the seed layer 210 may not be a continuous layer. For example, in some embodiments, no seed layer 210 material may be disposed on portions of the sidewalls 214 proximate the upper portion 226, 228 of the opening 212 or the upper corners 218 of the opening 212. The thickness of the seed layer may change dependent upon feature size. In some embodiments, the seed layer thickness at the lower portion of the sidewall 232 may be more than twice of the seed layer thickness at the upper portion of the sidewall 232.

The process gas may comprise any gas suitable to form the plasma to etch the seed layer 210, for example such as an inert gas, such as argon (Ar), helium (He), krypton (Kr), neon (Ne), xenon (Xe), or the like. The process gas may be provided at a flow rate of between about 10 to about 300 sccm, or in some embodiments, about 100 sccm. The process gas may be formed into a plasma by coupling a source power to the process gas within the process chamber under suitable conditions to establish and maintain the plasma. For example, in some embodiments, about 5 kW to about 60 kW of DC power, or in some embodiments, about 20 kW of DC power may be provided to ignite the process gas and maintain the plasma. In some embodiments, a bias power may be applied to the substrate to facilitate directing ions from the plasma towards the substrate, thereby facilitating the etching process. In some embodiments, the bias power applied to the substrate for the high energy process regime may between -240 V to -750 V. For example, in some embodiments, the bias power may be about 50 W to about 2000 W, or in some embodiments about 600 W at a frequency of about 2 MHz to about 60 MHz, or about 13.56 MHz.

In addition to the above, additional process parameters may be utilized to facilitate etching/resputtering the seed layer 210. For example, in some embodiments, the process chamber may be maintained at a pressure of about 1 to about 50 mTorr. In addition, in some embodiments, the process chamber may be maintained at a temperature of about 20 to about 200 degrees Celsius.

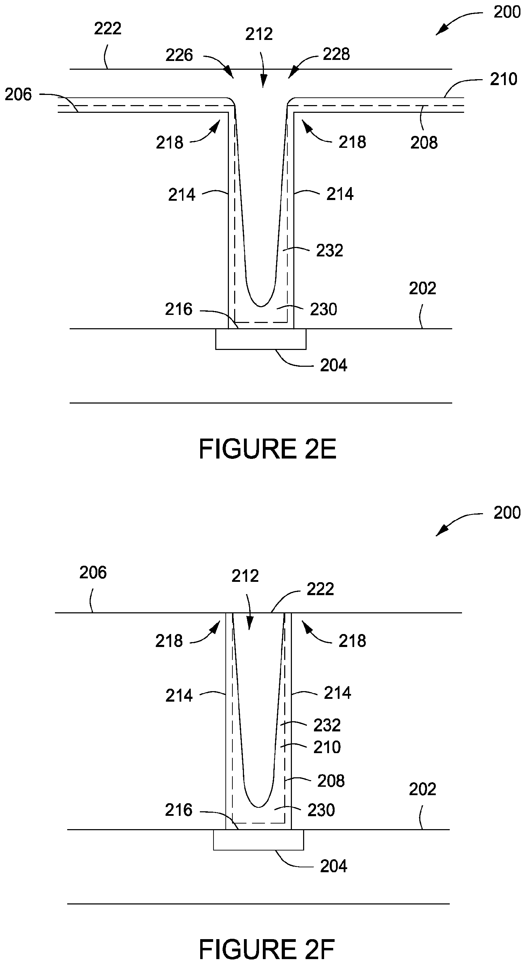

Next, at 112, a conductive material 222 may be deposited atop the seed layer 210 to fill the opening 212, as depicted in Figure 2E. In embodiments where the seed layer 210 does not form a continuous layer (described above), portions of the conductive material 222 may be deposited directly atop the barrier layer 208. The conductive material 222 may be deposited in any manner such as electrochemical deposition, or electrochemical plating (ECP), or the like. The conductive material 222 may be any suitable conductive material, such as aluminum (Al), copper (Cu), or the like.

In some embodiments, the inventors have observed that a growth rate of the conductive material 222 during deposition may increase as the thickness of the seed layer 210 increases. For example, in some embodiments, the growth rate of the conductive material 222 may be higher when deposited atop portions of the seed layer 210 having a greater thickness (*e.g*. the portions of the seed layer 210 disposed on the sidewalls proximate the bottom 216 of the opening 212 and the portions of the seed layer deposited on the bottom itself) as compared to the growth rate of the conductive material 222 when deposited atop portions of the seed layer 210 having a lower thickness (e.g. the portions of the seed layer 210 disposed on the sidewalls proximate the top of the opening 212 and the portions of the seed layer deposited on the upper corners 218). Accordingly, by providing the seed layer 210 having a sloped profile (as discussed above) the growth rate of the conductive material 222 may advantageously be greater proximate the bottom 216 of the opening 212, thereby allowing the opening 212 to be filled from the bottom 216 to the top. Filling the feature from the bottom 216 to the top may prevent an excess amount of conductive material 222 to form near the upper corners 218 of the feature, thereby preventing the opening 212 from being closed before fully filling the opening 212 with the conductive material 222.

After filling the opening 212 with the conductive material 222, chemical mechanical polishing (CMP) or other suitable technique may be used to remove the excess conductive material 222 outside the opening 212 (and any other features, such as other vias, trenches, dual damascene structures, or the like), as depicted in Figure 2F.

After depositing the conductive material 222 to fill the opening 212, the method generally ends and the substrate 200 may proceed for further processing, such as deposition, etch, annealing, or the like. For example, in some embodiments additional layers may be deposited, for example additional dielectric layers and/or metallization structures may be formed over the filled opening 212.

The inventive methods described herein may be performed in a process chamber as described below. Figure 3 illustrates a process chamber suitable for processing substrates in accordance with some embodiments of the present invention. Examples of suitable process chambers include the ENDURA® EXTENSA TTN and ENDURA® ENCORE processing chambers, both commercially available from Applied Materials, Inc., of Santa Clara, California. It is contemplated that other processing chambers, including those from other manufacturers, may also be utilized to perform the present invention.

In some embodiments, the processing chamber 300 contains a substrate support pedestal 352 for receiving the substrate 200 thereon, and a sputtering source, such as a target 342. The substrate support pedestal 352 may be located within a grounded chamber wall 350, which may be a chamber wall (as shown) or a grounded shield (not shown). The substrate support pedestal 352 may include any suitable means (not shown) of providing heat to the substrate 200, for example, such as a resistive heating element, radiant cavity and light source, or the like.

The target 342 may be supported on a grounded conductive aluminum adapter 344 through a dielectric isolator 346. The target 342 comprises a material to be deposited on the substrate 200 during sputtering, such as titanium when depositing a titanium nitride film in accordance with embodiments of the present invention.

The substrate support pedestal 352 has a material-receiving surface facing the principal surface of the target 342 and supports the substrate 200 to be sputter coated in planar position opposite to the principal surface of the target 342. The substrate support pedestal 352 may support the substrate 200 in a central region 340 of the processing chamber 300. The central region 340 is defined as the region above the substrate support pedestal 352 during processing (for example, between the target 342 and the substrate support pedestal 352 when in a processing position).

The substrate support pedestal 352 is vertically movable through a bellows 358 connected to a bottom chamber wall 360 to allow the substrate 200 to be transferred onto the substrate support pedestal 352 through a load lock valve (not shown) in the lower portion of processing the chamber 300 and thereafter raised to a deposition, or processing position as depicted in Figure 3. One or more processing gases may be supplied from a gas source 362 through a mass flow controller 364 into the lower part of the chamber 300. An exhaust port 368 may be provided and coupled to a pump (not shown) via a valve 366 for exhausting the interior of the processing chamber 300 and facilitating maintaining a desired pressure inside the processing chamber 300.

A controllable DC power source 348 may be coupled to the chamber 300 to apply a negative voltage, or bias, to the target 342. An RF power supply 356 may be coupled to the substrate support pedestal 352 in order to induce a negative DC bias on the substrate 200. In addition, in some embodiments, a negative DC self-bias may form on the substrate 200 during processing. In other applications, the substrate support pedestal 352 may be grounded or left electrically floating.

A rotatable magnetron 370 may be positioned proximate a back surface of the target 342. The magnetron 370 includes a plurality of magnets 372 supported by a base plate 374. The base plate 374 connects to a rotation shaft 376 coincident with the central axis of the chamber 300 and the substrate 200. The magnets 372 produce a magnetic field within the chamber 300, generally parallel and close to the surface of the target 342 to trap electrons and increase the local plasma density, which in turn increases the sputtering rate. The magnets 372 produce an electromagnetic field around the top of the chamber 300, and magnets 372 are rotated to rotate the electromagnetic field which influences the plasma density of the process to more uniformly sputter the target 342.

The chamber 300 further includes a grounded bottom shield 380 connected to a ledge 384 of the adapter 344. A dark space shield 386 is supported on the bottom shield 380 and is fastened to the shield 380 by screws or other suitable manner. The metallic threaded connection between the bottom shield 380 and the dark space shield 386 allows the two shields 380, 386 to be grounded to the adapter 344. The adapter 344 in turn is sealed and grounded to the aluminum chamber wall 350. Both shields 380, 386 are typically formed from hard, non-magnetic stainless steel.

The bottom shield 380 extends downwardly in an upper tubular portion 394 of a first diameter and a lower tubular portion 396 of a second diameter. The bottom shield 380 extends along the walls of the adapter 344 and the chamber wall 350 downwardly to below a top surface of the substrate support pedestal 352 and returns upwardly until reaching a top surface of the substrate support pedestal 352 (e.g., forming a u-shaped portion 398 at the bottom). A cover ring 302 rests on the top of the upwardly extending inner portion of the bottom shield 380 when the substrate support pedestal 352 is in its lower, loading position but rests on the outer periphery of the substrate support pedestal 352 when it is in its upper, deposition position to protect the substrate support pedestal 352 from sputter deposition. An additional deposition ring (not shown) may be used to shield the periphery of the substrate 200 from deposition.

An RF coil 304 may be disposed just outside the periphery of the substrate 200 in a lower half or third of the space between the target 342 and the substrate support pedestal 352. Multiple insulating supports (not shown) in the bottom shield 380 support the RF coil 304 and also supply RF power and grounding to the RF coil 304. The coil 304 may be a single-turn, nearly tubular coil composed of copper and having a small gap between the closely spaced electrical leads for power and grounding. An RF power supply 308 may be provided to supply RF power to the RF coil 304 to generate an argon plasma in a region removed from the target 342. The target 342 may be DC powered for sputter deposition and the RF coil 304 may be utilized for sputter etching of the substrate 200. However, in some embodiments , any combination of DC and RF power may power the two step DCE processes.

The chamber 300 may also be adapted to provide a more directional sputtering of material onto a substrate. In some embodiments, directional sputtering may be achieved by positioning an optional collimator 310 between the target 342 and the substrate support pedestal 352 to provide a more uniform and symmetrical flux of deposition material to the substrate 200.

The collimator 310, when present, may rest on the ledge portion of the bottom shield 380, thereby grounding the collimator 310. The collimator 310 may be a metal ring and may include an outer tubular section and at least one inner concentric tubular section, for example, three concentric tubular sections 312, 314, 316 linked by cross struts 320, 318. The outer tubular section 316 rests on the ledge portion 306 of the bottom shield 380. The use of the bottom shield 380 to support the collimator 310 simplifies the design and maintenance of the chamber 300. At least the two inner tubular sections 312, 314 are of sufficient height to define high aspect ratio apertures that partially collimate the sputtered particles. Further, the upper surface of the collimator 310 acts as a ground plane in opposition to the biased target 342, which facilitates keeping plasma electrons away from the substrate 200.

In some embodiments, a magnet 354 may be disposed about the chamber 300 for selectively providing a magnetic field between the substrate support pedestal 352 and the target 342. For example, as shown in Figure 3, the magnet 354 may be disposed about the outside of the chamber wall 350 in a region just above the substrate support pedestal 352 when in processing position. The magnet 354 may be an electromagnet and may be coupled to a power source (not shown) for controlling the magnitude of the magnetic field generated by the electromagnet.

A process controller 330 is coupled to various components of the process chamber 300 for controlling the operation thereof and comprises a central processing unit (CPU) 332, a memory 334, and support circuits 336 for the CPU 332. The process controller 330 may control the substrate processing apparatus directly, or via computers (or controllers) associated with particular process chamber and/or the support system components. The process controller 330 may be one of any form of general-purpose computer processor that can be used in an industrial setting for controlling various chambers and sub-processors. The memory, or computer-readable medium, 334 of the CPU 332 may be one or more of readily available memory such as random access memory (RAM), read only memory (ROM), floppy disk, hard disk, flash, or any other form of digital storage, local or remote. The support circuits 336 are coupled to the CPU 332 for supporting the processor in a conventional manner. These circuits include cache, power supplies, clock circuits, input/output circuitry and subsystems, and the like. Inventive methods as described herein may be stored in the memory 334 as software routine that may be executed or invoked to control the operation of the process chamber 300 in the manner described herein. The software routine may also be stored and/or executed by a second CPU (not shown) that is remotely located from the hardware being controlled by the CPU 332.

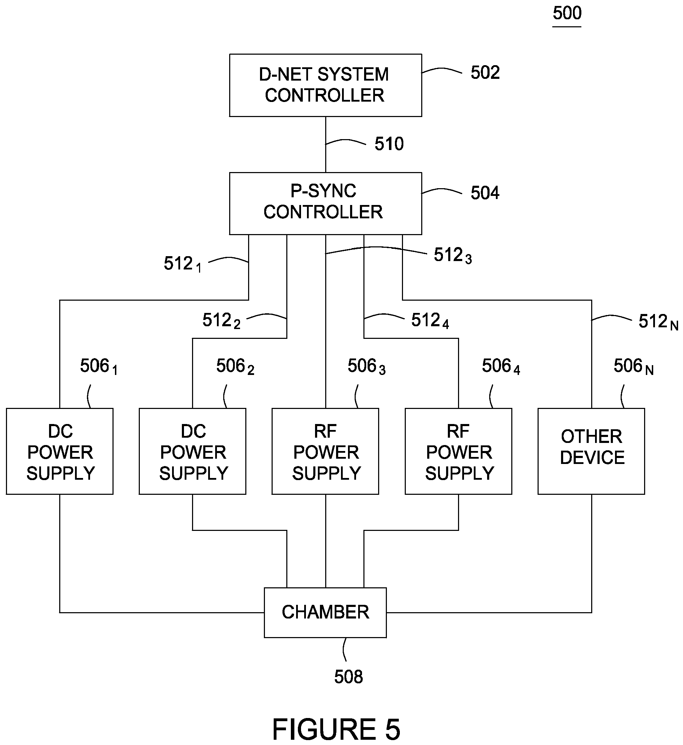

A synchronization controller 322 (described below in more detail with respect to Figure 5) is coupled to various components of the process chamber 300 for controlling the operation thereof and comprises a central processing unit (CPU) 324, a memory 326, and support circuits 328 for the CPU 324. The synchronization controller 322 may receive process parameters for a sub-set of substrate processing support systems from the process controller 330. For example, the synchronization controller 322 may receive process parameters for RF power supplies 308 and 356, DC power source 348, and optionally magnetron 370 from the process controller 330. The synchronization controller 322 may control these systems directly, or via computers (or controllers) associated the support system components. The synchronization controller 322 may be one of any form of general-purpose computer processor that can be used in an industrial setting for controlling various support systems and sub-processors. The memory, or computer-readable medium, 326 of the CPU 324 may be one or more of readily available memory such as random access memory (RAM), read only memory (ROM), floppy disk, hard disk, flash, or any other form of digital storage, local or remote. The support circuits 328 are coupled to the CPU 324 for supporting the processor in a conventional manner. These circuits include cache, power supplies, clock circuits, input/output circuitry and subsystems, and the like. Inventive methods as described herein may be stored in the memory 326 as software routine that may be executed or invoked to control the operation of selected support devices (e.g., power supplies) associated with process chamber 300 in the manner described herein, for example, such as described above with respect to the methods 100 and 600. The software routine may also be stored and/or executed by a second CPU (not shown) that is remotely located from the hardware being controlled by the CPU 324.

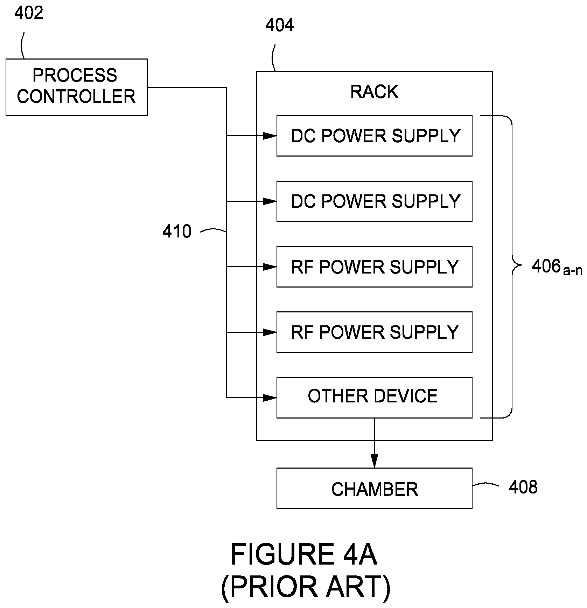

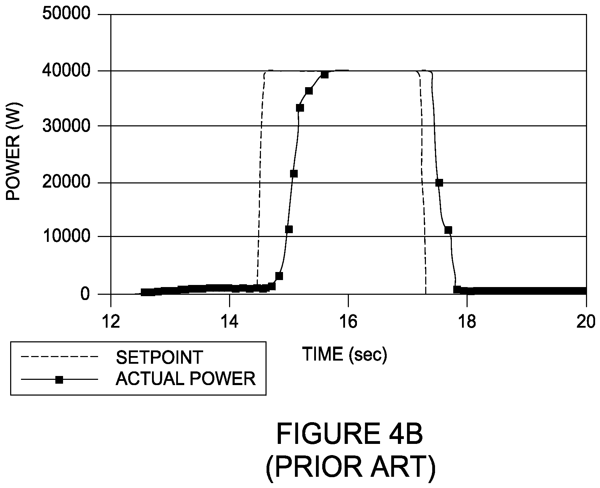

As discussed above, the inventors have observed that by synchronizing the sending of process parameters (*e.g*., magnetron position, electromagnet current, DC and RF powers) to reduce control signal transmission delays, improvements can be realized in deposition performance (step coverage, uniformity), repeatability of process results, and reliability of hardware components. Specifically, the inventors have observed that current methods of controlling DC and RF powers and electromagnet current through a process controller impart significant signal delays which greatly affect deposition performance and repeatability of process results. A substrate processing tool may have numerous process chambers and network nodes for communication with devices and power supplies. Typically, a central "real time" process controller 402 is used to coordinate the signals to all the devices 406ₐ₋ₙ over a shared network connection 410 as shown in Figure 4A. In the system as shown in Figure 4A, the inventors have observed that the process controller 402 is not truly "real time" but has delays up to 100 ms in signal processing between process components 406ₐ₋ₙ being controlled. The inventors have demonstrated that there are network delays and communication coding/decoding times which also contribute to a slower total response time for any given device on the network 410. Specifically, a process controller 402 may send all process parameters for devices 406ₐ₋ₙ required to perform a specific deposition process in chamber 408, for example, to the devices 406ₐ₋ₙ in device rack 404 over a shared network 410. However, due to network congestion on the shared network, devices may be delayed in receiving their operating instructions for performing the specific deposition process. Furthermore, adding to the delays are intrinsic delays associated with each device (e.g., internal signal processing and power cycling time of a power supply). The sum of these delays has been shown to be above 300 ms in some cases. For example, Figure 4B shows an idealized setpoint for applying power to effectuate a deposition process beginning at t=15 sec and removing all power at t=17 sec. However, signaling delays show the actual power applied and removed at different times. These delays also vary depending on how many systems may be attached to the process controller. Thus, for thin substrate films, the individual process recipes described above can be between 2 to 5 seconds in duration. With delay times, the actual results can vary significantly, as demonstrated by film thickness variations across the wafer and from wafer-to-wafer since the timing is not precise.

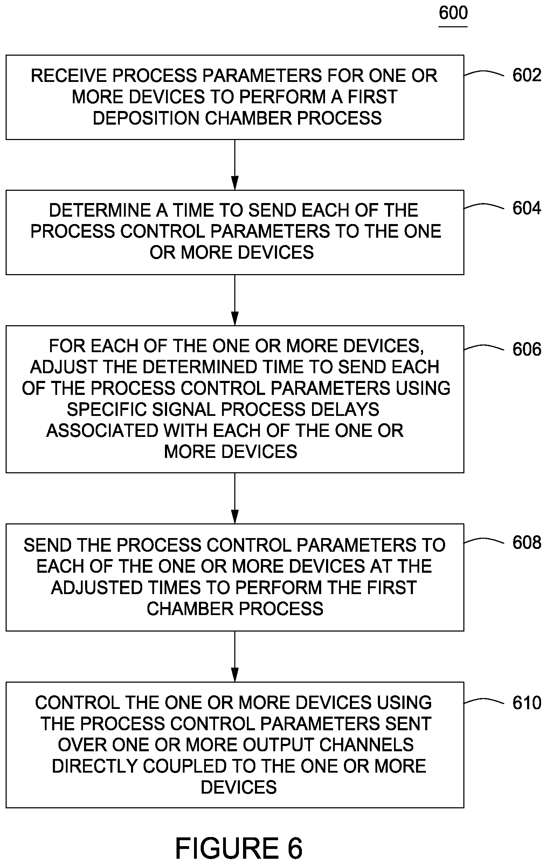

The inventors have observed that by synchronizing the sending of process parameters (*e.g*., magnetron position, electromagnet current, DC and RF powers, temperature, pressure, etc.), using direct communication lines to each of the devices, and taking into account the intrinsic delays associated with each device, improvements can be realized in deposition performance (step coverage, uniformity), repeatability of process results, and reliability of hardware components. By using a separate programmable synchronization controller 504, as shown in control system 500 of Figure 5, to synchronize the sending of process parameters, delay times for controlling power supplies, for example, can be greatly decreased. The synchronization controller 504 described here may be used as the synchronization controller 322 described above with respect to Figure 3. Figure 6 depicts and exemplary method 600 that may be performed by the synchronization controller 504 in Figure 5 and synchronization controller 322 described above with respect to Figure 3. The method 600 begins at 602 where the synchronization controller 504 receives process control parameters for one or more devices 506₁₋ₙ from a process controller 502 over link 510 to perform, for example, a first deposition chamber process in chamber 508.

After the synchronization controller 504 receives the process parameters for performing the first deposition chamber process, at step 604, the synchronization controller 504 determines a time to send each of the process control parameters to the one or more devices 506₁₋ₙ using information contained in the process control parameters. At step 606, for each of the one or more devices 506₁₋ₙ, the synchronization controller 504 will adjust the determined time to send each of the process control parameters using specific signal process delays (e.g., intrinsic delays) associated with each of the one or more devices 506₁₋ₙ. At step 608, the synchronization controller will send the process control parameters to each of the one or more devices 506₁₋ₙ at the adjusted times to perform the first chamber process. In some embodiments, each device of the one or more devices 506₁₋ₙ is controlled by the synchronization controller 504 using process control parameters sent on the output channel directly coupled to an analog control port of the device in step 610. In some embodiments, the process control parameters are received in a digital format from the process controller, and the synchronization controller 504 converts the digital process control parameters for each device into analog signals to be sent to and control each of the one or more devices 506₁₋ₙ. In some embodiments, the act of sending the process control parameters to the one or more devices at the adjusted time includes sending the analog signals corresponding to the process control parameters separately to each of the one or more devices over each channel directly coupled to one of the one or more devices.

In some embodiments, the synchronization controller 504 will wait until all process control parameters are received and will synchronize the sending of the process control parameters to each of the one or more devices 506₁₋ₙ. Synchronizing the sending of process control parameters to each of the one or more devices 506₁₋ₙ may include sending control signals to each of the one or more devices 506₁₋ₙ simultaneously (in parallel) over one or more output channels 512₁₋ₙ, where each channel is directly coupled to one of the one or more devices channel directly coupled to analog control ports on each of the one or more devices 506₁₋ₙ. In other embodiments, output channels 512₁₋ₙ may be coupled to more than one device that are not used simultaneously in the same substrate process chamber process. In some embodiments, the length of signal conductors to each of the one or more devices 506₁₋ₙ do not need to be the same length.

In some embodiments, each of the one or more devices may be controlled by the synchronization controller 504 at step 606 using process control parameters sent on the output channel 512₁₋ₙ directly coupled to the control port of the device. Each of the one or more devices 506₁₋ₙ may then supply the specified power, or substrate support process, as appropriate, to chamber 508.

An example of method 600 that may be performed by synchronization controller 322 in Figure 3 and synchronization controller 504 in Figure 5 is described below. For example, in some embodiments, the first deposition process may be a first DCE process where metal (*e.g.*, Cu) ions are to be deposited on a substrate using a low energy process regime to build the bottom of a feature on the substrate. The synchronization controller 504 will receive all the necessary process parameters for the one or more devices 506₁₋ₙ used in first chamber process from process controller 502. For example, the first chamber process may require activating two DC power supplies at t=15 seconds to supply -120V to chamber 508 for 2 seconds, and activating two RF power supplies at t=17 to supply -240 to chamber 508 for 3 seconds. The synchronization controller 504 will send the necessary process parameters directly to controls ports on DC power supplies 506₁ and 506₂ over output channels 512₁ and 512₂ simultaneously (in parallel) at t=15 to provide the required power. At t=17, the synchronization controller 504 will simultaneously (in parallel) send the necessary process parameters directly to controls ports on DC power supplies 506₁ and 506₂ over output channels 512₁ and 512₂ to shut off, and to controls ports on RF power supplies 506₃ and 506₄ over output channels 512₃ and 512₄ to turn on. The inventors have discovered that in embodiments of the present invention discussed above, synchronization of DC and RF power supply response times have been improved from 300ms delay to 30ms delay. As such, each device will essentially receive the required processing parameters substantially at the same time (i.e., with minimal delays) and will more closely match an ideal setpoint for required power.

In some embodiments, the process parameters received by synchronization controller 504 may be in the form of packet data for controlling each device 506₁₋ₙ. Each device 506₁₋ₙ may require a different data/signaling format for interfacing with the device. Conversions of the process parameters to control each device 506₁₋ₙ may be performed by process controller 502 or by synchronization controller 504.

In some embodiments, processes other than deposition processes may be performed by the control system 500. In addition, synchronization controller 504 may be used to control pressure systems, temperature systems, magnetron assemblies, or any other devices that may be controlled for use in substrate processing.

While the foregoing is directed to embodiments of the present invention, other and further embodiments of the invention may be devised without departing from the basic scope thereof, and the scope thereof is determined by the claims that follow.

## Claims

1. A method (600) for processing a substrate (200) in a process chamber (300; 508), comprising:
receiving (602), by a synchronization controller (322; 504), process control parameters for one or more devices (308, 356, 348, 370; 506₁₋ₙ) from a process controller (330; 502) to perform a first chamber process;
determining (604), by the synchronization controller, a time to send each of the process control parameters to the one or more devices;
for each of the one or more devices, adjusting (606), by the synchronization controller, the determined time to send each of the process control parameters using specific signal process delays associated with each of the one or more devices wherein the specific signal processing delays include intrinsic delays associated with each of the one or more devices; and
sending (608), by the synchronization controller, the process control parameters to each of the one or more devices at the adjusted times to perform the first chamber process, wherein the synchronization controller includes one or more output channels (512₁₋ₙ), each channel directly coupled to one of the one or more devices.

2. The method of claim 1, wherein each device of the one or more devices is controlled by the synchronization controller using process control parameters sent on the output channel directly coupled to a control port of the device.

3. The method of claim 1, wherein the process control parameters are received in a digital format from the process controller, and wherein the synchronization controller converts the digital process control parameters for each device into analog signals to be sent to and control each of the one or more devices.

4. The method of claim 3, wherein the act of sending the process control parameters to the one or more devices at the adjusted time includes sending the analog signals corresponding to the process control parameters separately to each of the one or more devices over each channel directly coupled to one of the one or more devices.

5. The method of any of claims 1-4, wherein the first chamber process is a deposition process performed using a first energy process regime to build up a bottom portion (230) of one or more features (212) formed on the substrate with a first material.

6. The method of claim 5, further comprising:
receiving, by the synchronization controller, a second set of process control parameters for a second set of one or more devices from the process controller to perform a second chamber process;
determining, by the synchronization controller, a time to send each of the second set of process control parameters to the second set of one or more devices;
for each of the second set of one or more devices, adjusting, by the synchronization controller, the determined time to send each of the second set of process control parameters using specific signal process delays associated with each of the second set of one or more devices; and
sending, by the synchronization controller, the second set of process control parameters to each of the second set of one or more devices at the adjusted times to perform the second chamber process, wherein the synchronization controller includes an output channel directly coupled to each of the second set of one or more devices.

7. The method of claim 6, wherein the second chamber process is a resputtering process performed using a second energy process regime to redistribute the first material from the bottom portion of the one or more features to a sidewall (214) of the one or more features, and wherein the second energy process regime is higher than the first energy process regime.

8. The method of claim 7, wherein the first material disposed along the sidewall of the one or more features has a first thickness after the first chamber process, wherein the first material disposed along the sidewall of the one or more features has a second thickness after the second chamber process, and wherein the second thickness is greater than the first thickness.

9. The method of claim 7, wherein the first chamber process is a deposition process, and wherein the second chamber process is a resputtering process.

10. The method of any of claims 1-4, wherein at least one of the one or more devices is a power supply, and wherein the process parameter received by the synchronization controller for the power supply includes (a) an energy level and (b) a time parameter when to apply the energy level.

11. The method of any of claims 1-4, wherein process control parameters are sent to each of the one or more devices at the adjusted times to perform the first chamber process such that each of the one or more devices receives the process control parameters substantially at the same time.

12. A substrate processing system (500), comprising:
a synchronization controller (322; 504) having one or more inputs to receive process control parameters of one or more devices (308, 356, 348, 370; 506₁₋ₙ) from a process controller (330; 502), and one or more output channels (512₁₋ₙ), each output channel directly coupled to one of the one or more devices, wherein the synchronization controller is configured to (a) receive the process control parameters, (b) determine a time to send each of the process control parameters to the one or more devices, (c) for each of the one or more devices, adjust the determined time to send each of the process control parameters using specific signal process delays associated with each of the one or more devices, wherein the specific signal processing delays include intrinsic delays associated with each of the one or more devices, and (d) send the process control parameters to each of the one or more devices at the adjusted times to perform a first chamber process.

13. The substrate processing system of claim 13, wherein each device of the one or more devices is controlled by the synchronization controller using process control parameters sent on the output channel directly coupled to a control port of the device.

## Patentansprüche

1. Verfahren (600) zur Bearbeitung eines Substrats (200) in einer Prozesskammer (300; 508), umfassend:
Empfangen (602), durch eine Synchronisationssteuerungseinrichtung (322; 504), von Prozesssteuerungsparametern für eine oder mehrere Vorrichtungen (308, 356, 348, 370; 506₁₋ₙ) von einer Prozesssteuerungseinrichtung (330; 502), um einen ersten Kammerprozess durchzuführen;
Bestimmen (604), durch die Synchronisationssteuerungseinrichtung, einer Zeit zum Senden von jedem der Prozesssteuerungsparameter an die eine oder die mehreren Vorrichtungen;
für jede der einen oder mehreren Vorrichtungen Einstellen (606), durch die Synchronisationssteuerungseinrichtung, der bestimmten Zeit zum Senden von jedem der Prozesssteuerungsparameter unter Verwendung spezifischer Signalverarbeitungsverzögerungen, die mit jeder der einen oder mehreren Vorrichtungen verknüpft sind, wobei die spezifischen Signalverarbeitungsverzögerungen intrinsische Verzögerungen beinhalten, die mit jeder der einen oder mehreren Vorrichtungen verknüpft sind; und
Senden (608), durch die Synchronisationssteuerungseinrichtung, der Prozesssteuerungsparameter an jede der einen oder mehreren Vorrichtungen zu den eingestellten Zeiten, um den ersten Kammerprozess durchzuführen, wobei die Synchronisationssteuerungseinrichtung einen oder mehrere Ausgangskanäle (512₁₋ₙ) beinhaltet, wobei jeder Kanal direkt mit einer der einen oder mehreren Vorrichtungen gekoppelt ist.

2. Verfahren nach Anspruch 1, wobei jede Vorrichtung der einen oder mehreren Vorrichtungen durch die Synchronisationssteuerungseinrichtung gesteuert wird, indem Prozesssteuerungsparameter verwendet werden, die auf dem Ausgangskanal gesendet werden, der direkt mit einem Steuerungsanschluss der Vorrichtung gekoppelt ist.

3. Verfahren nach Anspruch 1, wobei die Prozesssteuerungsparameter in einem digitalen Format von der Prozesssteuerungseinrichtung empfangen werden und wobei die Synchronisationssteuerungseinrichtung die digitalen Prozesssteuerungsparameter für jede Vorrichtung in analoge Signale umwandelt, die an jede der einen oder mehreren Vorrichtungen zu senden sind und diese steuern.

4. Verfahren nach Anspruch 3, wobei der Vorgang des Sendens der Prozesssteuerungsparameter an die eine oder die mehreren Vorrichtungen zu der eingestellten Zeit das Senden der den Prozesssteuerungsparametern entsprechenden analogen Signale separat an jede der einen oder mehreren Vorrichtungen über jeden Kanal beinhaltet, der direkt mit einer der einen oder mehreren Vorrichtungen gekoppelt ist.

5. Verfahren nach einem der Ansprüche 1 bis 4, wobei der erste Kammerprozess ein Abscheidungsprozess ist, der unter Verwendung eines ersten Energieprozessregimes durchgeführt wird, um einen unteren Abschnitt (230) von einem oder mehreren Merkmalen (212) aufzubauen, die auf dem Substrat mit einem ersten Material gebildet sind.

6. Verfahren nach Anspruch 5, ferner umfassend:
Empfangen, durch die Synchronisationssteuerungseinrichtung, eines zweiten Satzes von Prozesssteuerungsparametern für einen zweiten Satz von einer oder mehreren Vorrichtungen von der Prozesssteuerungseinrichtung, um einen zweiten Kammerprozess durchzuführen;
Bestimmen, durch die Synchronisationssteuerungseinrichtung, einer Zeit zum Senden von jedem des zweiten Satzes von Prozesssteuerungsparametern an den zweiten Satz von einer oder mehreren Vorrichtungen;
für jeden des zweiten Satzes von einer oder mehreren Vorrichtungen, Einstellen, durch die Synchronisationssteuerungseinrichtung, der bestimmten Zeit zum Senden von jedem des zweiten Satzes von Prozesssteuerungsparametern unter Verwendung spezifischer Signalverarbeitungsverzögerungen, die mit jeder des zweiten Satzes von einer oder mehreren Vorrichtungen verknüpft sind; und
Senden, durch die Synchronisationssteuerungseinrichtung, des zweiten Satzes von Prozesssteuerungsparametern an jeden des zweiten Satzes von einer oder mehreren Vorrichtungen zu den eingestellten Zeiten, um den zweiten Kammerprozess durchzuführen, wobei die Synchronisationssteuerungseinrichtung einen Ausgangskanal beinhaltet, der direkt mit jeder des zweiten Satzes von einer oder mehreren Vorrichtungen verknüpft ist.

7. Verfahren nach Anspruch 6, wobei der zweite Kammerprozess ein Resputtering-Prozess ist, der unter Verwendung eines zweiten Energieprozessregimes durchgeführt wird, um das erste Material von dem unteren Abschnitt des einen oder der mehreren Merkmale zu einer Seitenwand (214) des einen oder der mehreren Merkmale umzuverteilen, und wobei das zweite Energieprozessregime höher als das erste Energieprozessregime ist.

8. Verfahren nach Anspruch 7, wobei das erste Material, das entlang der Seitenwand des einen oder der mehreren Merkmale abgeschieden wird, nach dem ersten Kammerprozess eine erste Dicke aufweist, wobei das erste Material, das entlang der Seitenwand des einen oder der mehreren Merkmale abgeschieden wird, nach dem zweiten Kammerprozess eine zweiten Dicke aufweist, und wobei die zweite Dicke größer als die erste Dicke ist.

9. Verfahren nach Anspruch 7, wobei der erste Kammerprozess ein Abscheidungsprozess ist, und wobei der zweite Kammerprozess ein Resputtering-Prozess ist.

10. Verfahren nach einem der Ansprüche 1 bis 4, wobei wenigstens eine der einen oder mehreren Vorrichtungen eine Leistungszufuhr ist, und wobei der durch die Synchronisationssteuerungseinrichtung empfangene Prozessparameter für die Leistungszufuhr (a) ein Energieniveau und (b) einen Zeitparameter, wann das Energieniveau anzulegen ist, beinhaltet.

11. Verfahren nach einem der Ansprüche 1 bis 4, wobei Prozesssteuerungsparameter an jede der einen oder mehreren Vorrichtungen zu den eingestellten Zeiten gesendet werden, um den ersten Kammerprozess durchzuführen, sodass jede der einen oder mehreren Vorrichtungen die Prozesssteuerungsparameter im Wesentlichen zur gleichen Zeit empfängt.

12. Substratbearbeitungssystem (500), umfassend:
eine Synchronisationssteuerungseinrichtung (322; 504), die einen oder mehrere Eingänge aufweist, um Prozesssteuerungsparameter einer oder mehrerer Vorrichtungen (308, 356, 348, 370; 506₁₋ₙ) von einer Prozesssteuerungseinrichtung (330; 502) zu empfangen, und einen oder mehrere Ausgangskanäle (512₁₋ₙ) aufweist, wobei jeder Ausgangskanal direkt mit einer der einen oder mehreren Vorrichtungen gekoppelt ist, wobei die Synchronisationssteuerungseinrichtung dafür ausgelegt ist, (a) die Prozesssteuerungsparameter zu empfangen, (b) eine Zeit zum Senden von jedem der Prozesssteuerungsparameter an die eine oder die mehreren Vorrichtungen zu bestimmen, (c) für jede der einen oder mehreren Vorrichtungen die bestimmte Zeit zum Senden von jedem der Prozesssteuerungsparameter unter Verwendung spezifischer Signalverarbeitungsverzögerungen einzustellen, die mit jeder der einen oder mehreren Vorrichtungen verknüpft sind, wobei die spezifischen Signalverarbeitungsverzögerungen intrinsische Verzögerungen beinhalten, die mit jeder der einen oder mehreren Vorrichtungen verknüpft sind, und (d) die Prozesssteuerungsparameter an jede der einen oder mehreren Vorrichtungen zu den eingestellten Zeiten zu senden, um einen ersten Kammerprozess durchzuführen.

13. Substratbearbeitungssystem nach Anspruch 13, wobei jede Vorrichtung der einen oder mehreren Vorrichtungen durch die Synchronisationssteuerungseinrichtung gesteuert wird, wobei Prozesssteuerungsparameter verwendet werden, die auf dem Ausgangskanal gesendet werden, der direkt mit einem Steuerungsanschluss der Vorrichtung gekoppelt ist.

## Revendications

1. Procédé (600) de traitement d'un substrat (200) dans une chambre de traitement (300 ; 508), comprenant :
la réception (602), par un dispositif de commande de synchronisation (322 ; 504), de paramètres de commande de traitement pour un ou plusieurs dispositifs (308, 356, 348, 370 ; 506₁₋ₙ) à partir d'un dispositif de commande de traitement (330 ; 502) pour réaliser un premier traitement en chambre ;
la détermination (604), par le dispositif de commande de synchronisation, d'un temps pour envoyer chacun des paramètres de commande de traitement aux un ou plusieurs dispositifs ;
pour chacun des un ou plusieurs dispositifs, l'ajustement (606), par le dispositif de commande de synchronisation, du temps déterminé pour envoyer chacun des paramètres de commande de traitement en utilisant des retards de traitement de signal spécifiques associés à chacun des un ou plusieurs dispositifs dans lequel les retards de traitement de signal spécifiques incluent des retards intrinsèques associés à chacun des un ou plusieurs dispositifs ; et
l'envoi (608), par le dispositif de commande de synchronisation, des paramètres de commande de traitement à chacun des un ou plusieurs dispositifs aux temps ajustés pour réaliser le premier traitement en chambre, dans lequel le dispositif de commande de synchronisation inclut un ou plusieurs canaux de sortie (512₁₋ₙ), chaque canal directement couplé à l'un des un ou plusieurs dispositifs.

2. Procédé selon la revendication 1, dans lequel chaque dispositif parmi les un ou plusieurs dispositifs est commandé par le dispositif de commande de synchronisation en utilisant des paramètres de commande de traitement envoyés sur le canal de sortie directement couplé à un port de commande du dispositif.

3. Procédé selon la revendication 1, dans lequel les paramètres de commande de traitement sont reçus dans un format numérique à partir du dispositif de commande de traitement, et dans lequel le dispositif de commande de synchronisation convertit les paramètres de commande de traitement numérique pour chaque dispositif en signaux analogiques devant être envoyés vers et commander chacun des un ou plusieurs dispositifs.

4. Procédé selon la revendication 3, dans lequel l'acte d'envoyer les paramètres de commande de traitement aux un ou plusieurs dispositifs au temps ajusté inclut l'envoi des signaux analogiques correspondant aux paramètres de commande de traitement séparément de chacun des un ou plusieurs dispositifs sur chaque canal directement couplé à l'un des un ou plusieurs dispositifs.

5. Procédé selon l'une quelconque des revendications 1 à 4, dans lequel le premier traitement en chambre est un traitement de dépôt réalisé en utilisant un premier régime de traitement d'énergie pour construire une partie inférieure (230) d'un ou plusieurs éléments (212) formés sur le substrat avec un premier matériau.

6. Procédé selon la revendication 5, comprenant en outre :
la réception, par le dispositif de commande de synchronisation, d'un second ensemble de paramètres de commande de traitement pour un second ensemble d'un ou plusieurs dispositifs à partir du dispositif de commande de traitement pour réaliser un second traitement en chambre ;
la détermination, par le dispositif de commande de synchronisation, d'un temps pour envoyer chacun du second ensemble de paramètres de commande de traitement au second ensemble d'un ou plusieurs dispositifs ;
pour chacun du second ensemble d'un ou plusieurs dispositifs, l'ajustement, par le dispositif de commande de synchronisation, du temps déterminé pour envoyer chacun du second ensemble de paramètres de commande de traitement en utilisant des retards de traitement de signal spécifiques associés à chacun du second ensemble d'un ou plusieurs dispositifs ; et
l'envoi, par le dispositif de commande de synchronisation, du second ensemble de paramètres de commande de traitement à chacun du second ensemble d'un ou plusieurs dispositifs aux temps ajustés pour réaliser le second traitement en chambre, dans lequel le dispositif de commande de synchronisation inclut un canal de sortie directement couplé à chacun du second ensemble d'un ou plusieurs dispositifs.

7. Procédé selon la revendication 6, dans lequel le second traitement en chambre est un traitement de repulvérisation réalisé en utilisant un second régime de traitement d'énergie pour redistribuer le premier matériau de la partie inférieure des un ou plusieurs éléments à une paroi (214) des un ou plusieurs éléments, et dans lequel le second régime de traitement d'énergie est supérieur au premier régime de traitement d'énergie.

8. Procédé selon la revendication 7, dans lequel le premier matériau disposé le long de la paroi des un ou plusieurs éléments a une première épaisseur après le premier traitement en chambre, dans lequel le premier matériau disposé le long de la paroi des un ou plusieurs éléments a une seconde épaisseur après le second traitement en chambre, et dans lequel la seconde épaisseur est supérieure à la première épaisseur.

9. Procédé selon la revendication 7, dans lequel le premier traitement en chambre est un traitement de dépôt, et dans lequel le second traitement en chambre est un traitement de repulvérisation.

10. Procédé selon l'une quelconque des revendications 1 à 4, dans lequel au moins l'un des un ou plusieurs dispositifs est une alimentation électrique, et dans lequel le paramètre de traitement reçu par le dispositif de commande de synchronisation pour l'alimentation électrique inclut (a) un niveau d'énergie et (b) un paramètre de temps indiquant le moment où il convient d'appliquer le niveau d'énergie.

11. Procédé selon l'une quelconque des revendications 1 à 4, dans lequel des paramètres de commande de traitement sont envoyés à chacun des un ou plusieurs dispositifs aux temps ajustés pour réaliser le premier traitement en chambre de telle manière que chacun des un ou plusieurs dispositifs reçoit les paramètres de commande de traitement sensiblement en même temps.

12. Système de traitement de substrat (500), comprenant :
un dispositif de commande de synchronisation (322 ; 504) ayant une ou plusieurs entrées pour recevoir des paramètres de commande de traitement d'un ou plusieurs dispositifs (308, 356, 348, 370 ; 506₁₋ₙ) à partir d'un dispositif de commande de traitement (330 ; 502), et un ou plusieurs canaux de sortie (512₁₋ₙ), chaque canal de sortie directement couplé à l'un des un ou plusieurs dispositifs, dans lequel le dispositif de commande de synchronisation est configuré pour (a) recevoir les paramètres de commande de traitement, (b) déterminer un temps pour envoyer chacun des paramètres de commande de traitement aux un ou plusieurs dispositifs, (c) pour chacun des un ou plusieurs dispositifs, ajuster le temps déterminé pour envoyer chacun des paramètres de commande de traitement en utilisant des retards de traitement de signal spécifiques associés à chacun des un ou plusieurs dispositifs, dans lequel les retards de traitement de signal spécifiques incluent des retards intrinsèques associés à chacun des un ou plusieurs dispositifs, et (d) envoyer les paramètres de commande de traitement à chacun des un ou plusieurs dispositifs aux temps ajustés pour réaliser un premier traitement en chambre.

13. Système de traitement de substrat selon la revendication 13, dans lequel chaque dispositif parmi les un ou plusieurs dispositifs est commandé par le dispositif de commande de synchronisation en utilisant des paramètres de commande de traitement envoyés sur le canal de sortie directement couplé à un port de commande du dispositif.
